Europäisches Patentamt

European Patent Office

Office européen des brevets

(11) Publication number: **0 330 142**
**A2**

# EUROPEAN PATENT APPLICATION

(21) Application number: 89102993.6

(22) Date of filing: 21.02.89

(51) Int. Cl.⁴: **H01L 29/60 , H01L 29/80 , H01L 29/78 , H01L 27/08 , H01L 27/06**

(30) Priority: 22.02.88 JP 39153/88

(43) Date of publication of application:
30.08.89 Bulletin 89/35

(84) Designated Contracting States:
DE FR GB

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Kishita, Yoshihiro**
**c/o Patent Division K.K.Toshiba**
**1-1 Shibaura 1-chome Minato-ku Tokyo**
**105(JP)**
Inventor: **Tomisawa, Yutaka**
**c/o Patent Division K.K.Toshiba**
**1-1 Shibaura 1-chome Minato-ku Tokyo**
**105(JP)**
Inventor: **Tanimata, Shoichi**
**c/o Patent Division K.K.Toshiba**
**1-1 Shibaura 1-chome Minato-ku Tokyo**
**105(JP)**

(74) Representative: **Henkel, Feiler, Hänzel &**
**Partner**
**Möhlstrasse 37**
**D-8000 München 80(DE)**

(54) **Multi-gate field-effect transistor.**

(57) A field-effect transistor structure comprising a semiconductor substrate (1), a drain region (3) and a source region (4) on the substrate (1), a drain electrode (5) connected to the drain region (3), a source electrode (6) connected to the source region (4), and two or more divided gate electrodes (18, 19) on the substrate (1).

F I G. 1 A

F I G. 1B

F I G. 1C

## Multi-gate field-effect transistor

The present invention relates to a semiconductor device in which an MES or MOS field-effect transistor and resistance elements are integrated on one semiconductor substrate, and more specifically, to a semiconductor device in which gate electrodes are divided to be adapted for a plurality of frequency bands.

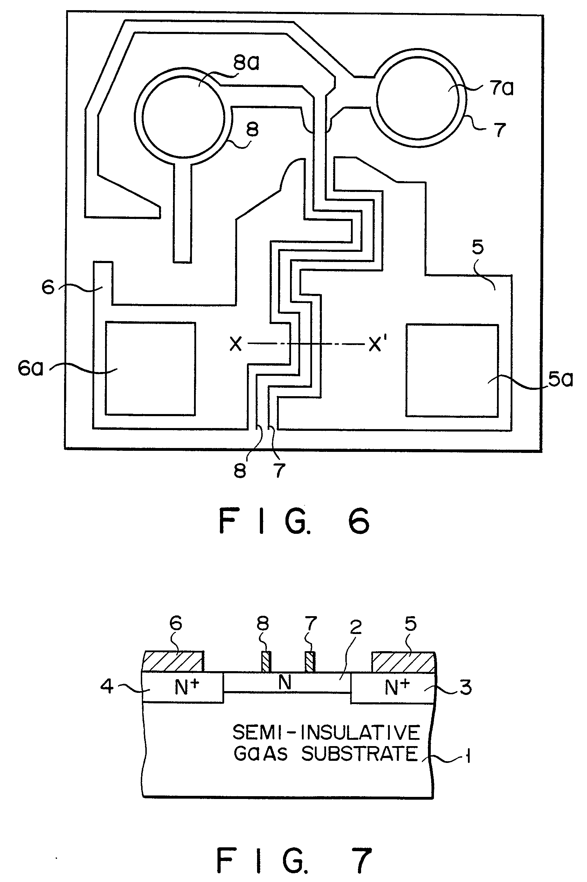

High-frequency circuits for use in the VHF or UHF band are continually improving in performance. As a prior art example of a semiconductor device used in a UHF high-frequency circuit, a GaAs dual-gate MES FET for a TV tuner will now be described with reference to the accompanying drawings of Figs. 6 and 7. Fig. 6 is a plan view schematically showing an electrode arrangement of the MES FET, and Fig. 7 is a sectional view taken along line X-X' of Fig. 6. In Fig. 7, operating layer 2 is formed on semi-insulating GaAs substrate 1, and $N^+$ drain region 3 and $N^+$ source region 4 are disposed adjacent to layer 2. Drain electrode 5 is in ohmic contact with region 3, and part of electrode 5 extends over the substrate, thus forming drain electrode pad 5a (Fig. 6). Numerals 6 and 6a designate a source electrode and a source electrode pad, respectively. Second gate electrode 7 is provided on the drain-side portion of the operating layer to form a Schottky junction therewith. Electrode 7 has a gate length of .1 μm, for example. First gate electrode 8, whose gate width and length are equal to those of the second gate electrode, is provided on the source-side portion of the operating layer to form a Schottky junction therewith. The first and second gate electrodes partially extend over the substrate, thus forming first and second gate electrode pads 8a and 7a, respectively.

The amplification degree of the dual-gate MES FET can be controlled in accordance with potential Vg2 of the second gate electrode. If the MES FET is used for high-frequency amplification of the tuner, therefore, the second gate electrode is utilized for automatic gain control (AGC). Since the second gate electrode is situated between the drain electrode and the first gate electrode, electrostatic capacity Cdg between the drain electrode and the first gate electrode is smaller than that of a single-gate FET. Thus, the effect of feedback from the drain to the first gate electrode at the input end is too small to require the use of a neutralizing circuit. Having a low noise factor and these advantages, the dual-gate FET is used as a feedback element of the TV tuner circuit.

Conventionally, GaAs dual-gate MES FETs and silicon dual-gate MOS FETs are frequently used in the UHF and VHF bands, respectively. In this case, however, the circuits are bulky and complicated in construction.

Since various information transmission means, such as the CATV, broadcasting via satellite, etc., have recently been developed and started to be used, there is an increasing demand for additional channels and multi-function versions of household video apparatuses, represented by TV sets and VTRs. High-frequency circuits of these apparatuses, adapted for the VHF or UHF band, must receive and process high-frequency signals at a number of frequencies. Accordingly, there is an urgent request for the miniaturization of these circuits and improvements of their performance.

The object of the present invention is to provide a semiconductor device which is adapted for use in a plurality of frequency bands, and enjoys a high degree of freedom, and in which conventional independent elements are partially integrated on the same substrate, thus enabling production of multi-channel, multi-function versions of high-frequency circuits and the miniaturization thereof.

A semiconductor device of the present invention comprises an FET which has a drain electrode, a source electrode, and two divided gate electrodes.

In actually using a circuit, one or both of two gates G1a and G1b therein are connected to select a gate width best suited for the circuit. In other words, FETs with three different input capacities and gm values can be alternatively selected as required. Thus, the present invention can provide FETs which are adapted for use in varied frequency bands, and can enjoy various applications and a high degree of freedom of circuit design.

This invention can be more fully understood from the following detailed description when taken in conjunction with the accompanying drawings, in which:

Fig. 1A is a plan view showing a semiconductor device according to an embodiment of the present invention;

Fig. 1B is a partial, enlarged view of the semiconductor device shown in Fig. 1A;

Fig. 1C is a plan view showing an alternative application of the semiconductor device of the invention;

Fig. 2A is a plan view showing an embodiment of a dual FET in the semiconductor device of the invention;

Fig. 2B is a partial, enlarged view of the dual FET;

Fig. 2C is an electric circuit diagram of the semiconductor device of Fig. 2A;

Fig. 3 is an electric circuit diagram for illustrating the application of the device of the invention;

Figs. 4 and 5 are electric circuit diagrams showing semiconductor devices according to second and third embodiments, respectively, of the present invention;

Fig. 6 is a plan view of a prior art GaAs dual-gate MES FET;

Fig. 7 is a partial enlarged sectional view of the MES FET shown in Fig. 6;

Fig. 8 is a circuit diagram of a dual FET with three divided gate electrodes; and

Figs. 9A to 9D show circuit diagrams of various examples of bias circuits.

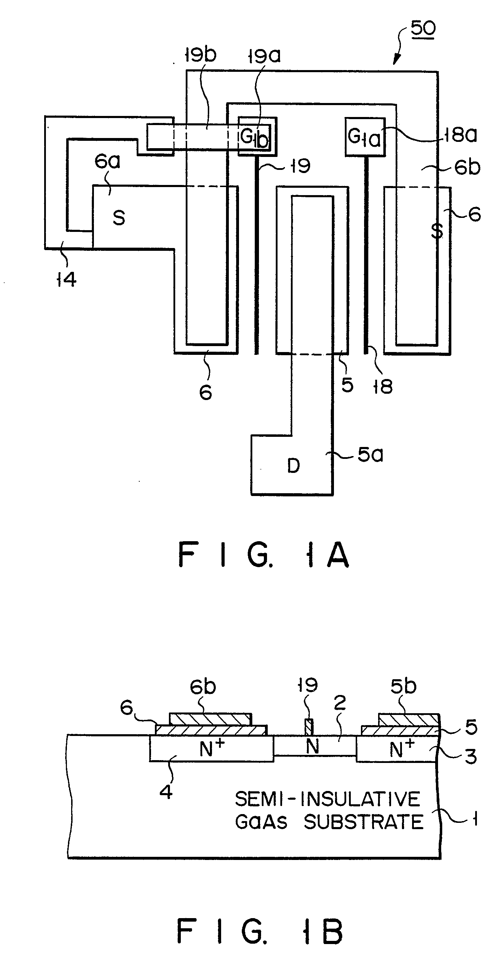

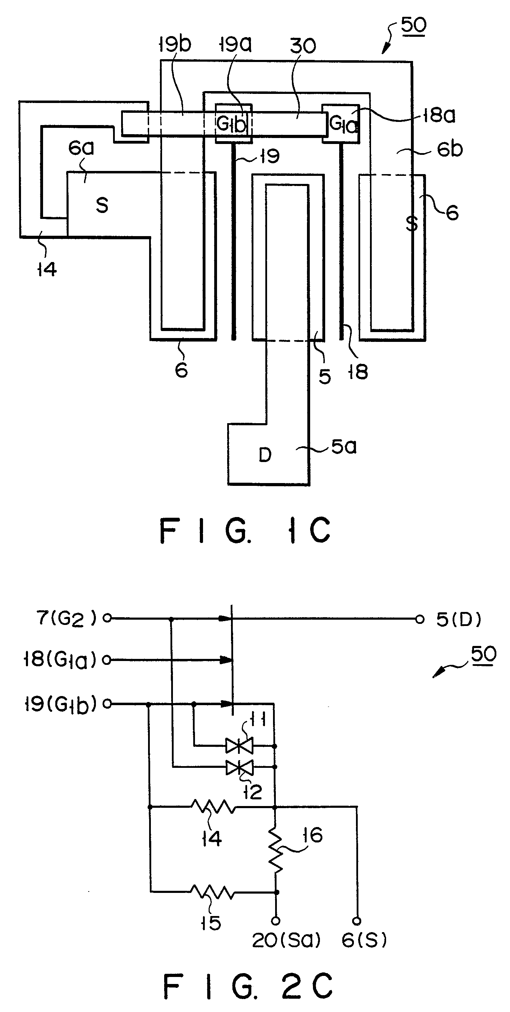

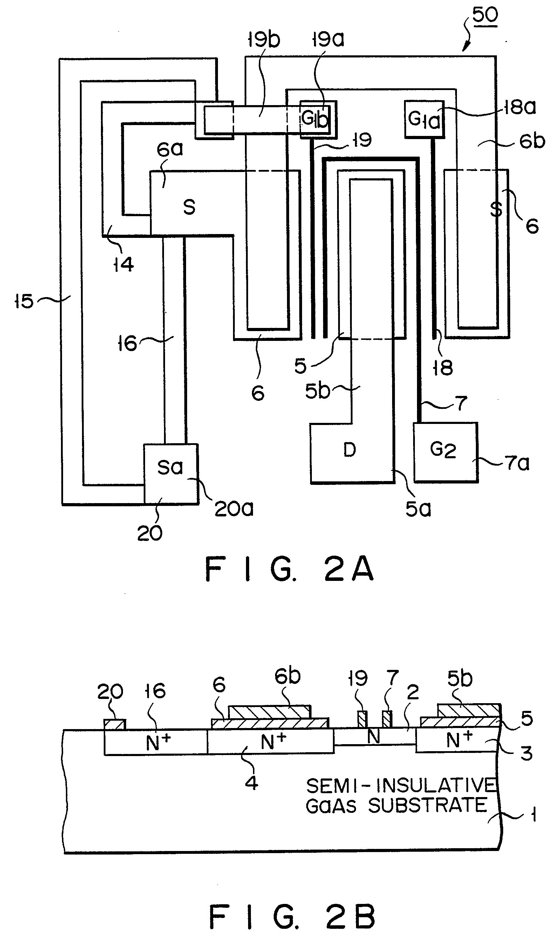

Fig. 2 shows a semiconductor device according to an embodiment of the present invention. The semiconductor device of this embodiment is a linear IC, in which a GaAs dual-gate MES FET, for use as a principal component, and a DC bias circuit for the FET are integrated on a semi-insulating GaAs substrate. Fig. 2A is a schematic plan view of the IC, mainly showing the arrangement of electrodes and a resistance film. Fig. 2B is a partial, enlarged sectional view schematically showing an FET and a resistance film connected thereto, and Fig. 2C is an electric circuit diagram of this linear IC. In these drawings and Figs. 1, 6 and 7, like reference numerals are used to designate like or corresponding portions. N-type operating layer 2, which is exposed on one main surface (on the upper side of Fig. 2B) of half-insulating GaAs substrate 1, and $N^+$ drain region 3 and $N^+$ source region 4, which are situated on either side of layer 2 so as to adjoin it, are selectively formed by Si-ion implantation. Drain electrode 5 and source electrode 6 are provided which are in ohmic contact with regions 3 and 4, respectively. Second gate electrode 7 is provided on the drain-side portion of the operating layer between drain and source electrodes 5 and 6, thus forming a Schottky junction. Also, first gate electrodes G1a18 and G1b19 are provided on the source-side portion of the operating layer between electrodes 5 and 6. Electrodes G1a18 and G1b19 are obtained by bisecting one gate electrode (corresponding to the conventional first gate electrode) which forms a Schottky junction in conjunction with the operating layer. Thus, two dual-gate MES FETs are formed which have drain electrode 5, second gate electrode 7, and source electrode 6 in common, and divided gate electrodes G1a18 and G1b19 as their respective first gate electrodes. In the present embodiment, first gate electrodes G1a and G1b and second gate electrode 7 have a gate length of 1 μm each. The gate width of each first gate electrode is 300 μm, while that of the second gate electrode is 600 μm.

Further, bias resistance film 16 and branch source electrode 20 are formed on substrate 1 so that electrode 20 is connected to source electrode 6 by means of film 16. The resistance film is formed by doping the GaAs substrate with Si ions. In the present embodiment, the resistance of the resistance film is set so that a voltage produced between the source electrode and the branch source electrode during the operation of the device is high enough to pinch off the operating layer directly under first gate electrode G1a. In this embodiment, moreover, bias resistance films 14 and 15 are used to determine the point of operation of the device, along with bias resistance film 16. One end of each of films 13 to 15 is connected to first gate electrode G1b19.

Numerals 5a, 6a, 7a, 18a, 19a and 20a designate electrode pads for bonding external connecting wires to the drain electrode, source electrode, second gate electrode, first gate electrodes G1a and G1b, and branch electrode Sa, respectively. Numerals 5b, 6b and 19b designate electrode wires for the drain electrode, source electrode, and first gate electrode G1b, respectively. Further, numerals 11 and 12 denote a pair of series-connected PN-junction diodes of opposite polarity, individually. Diodes 11 and 12 are used to protect the Schottky junctions of first gate electrode G1b and second electrode G2, respectively.

Constructed in this manner, linear IC 50 includes two FETs, having first gate electrodes with 300-μm gate width, and an FET whose gate width is 600 μm when connected together. Although these FETs have different gate widths, they are equal in all other dimensions, such as gate length, impurity concentration of the operating layer, thickness, etc. Accordingly, input capacity Cis between the first gate electrode and the source electrode and drain currents ID and gm are substantially proportional to the gate width, and the NF is improved in proportion to the frequency. These electrical characteristics were verified by trial.

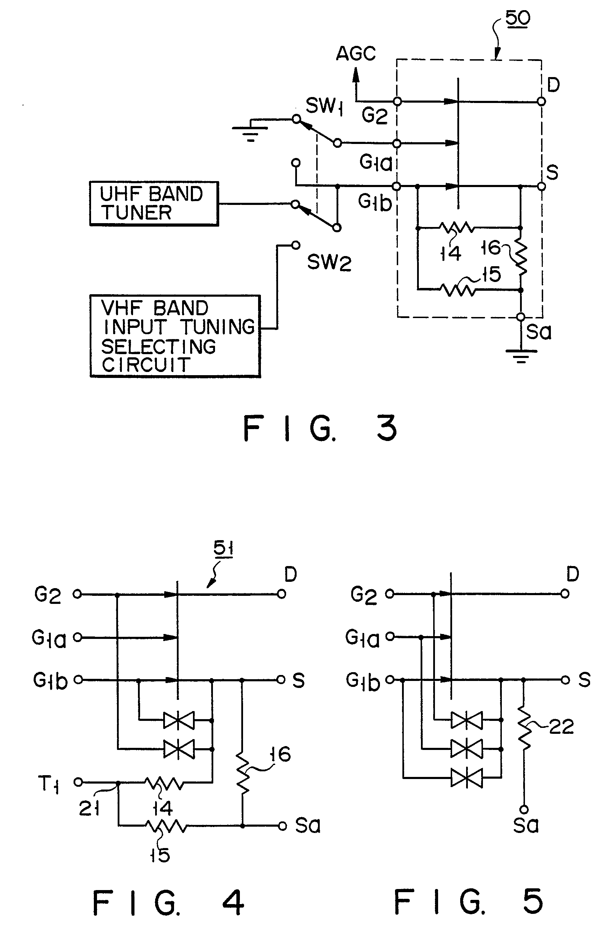

Fig. 3 is an electric circuit diagram showing an example of the application of linear IC 50 of the embodiment shown in Fig. 2. In Fig. 3, branch source electrode Sa is grounded, and second gate electrode G2 is connected to an automatic gain control (AGC) circuit. Symbols SW1 and SW2 designate external switches associated with each other, usually electronic devices such as switching diodes.

When external switch SW2 is connected to a UHF-band tuner, first gate electrode G1a is grounded, the potential of source electrode S is shifted to a level higher than the ground potential of bias resistance film 16, and that region of the operating layer directly under electrode G1a is pinched off. Accordingly, no drain current flows through the underlying region, so that electrode G1a cannot operate as an FET. Thus, only the FET with first gate electrode G1b, which is connected to the UHF-band tuner is in an operating state. Since this FET has a gate width as short as 300 μm, a small input capacity and a satisfactory NF, so it is suited for amplification in the UHF band of higher frequency. When external switch SW2 is connected to a VHF-band input tuning selecting circuit, first gate electrodes G1a and G1b are connected to each other, and operate as an FET of 600-μm gate width. In this case, although the gate width is longer and the input capacity is larger, drain current gm is so large that tuner circuits must be independently formed from a silicon transistor for the VHF band and a GaAs dual-gate transistor for the UHF band. By the use of a simple external switching circuit according to the present invention, however, the tuner circuits for the VHF and UHF bands can be partially integrated. Thus, a small-sized, high-performance circuit can be obtained.

Fig. 4 is an electric circuit diagram showing a second embodiment of the present invention. Linear IC 51 of this embodiment differs from linear IC 50 of the first embodiment in that junction 21 between DC bias resistance films 14 and 15 is separated from first gate electrode G1b, and a bonding pad is provided separately as external connecting terminal T1. Thus, in dual-gate MES FETs with first gate electrodes having three different gate widths, an electrode to be pinched off is connected to branch source electrode Sa, while an operating electrode is connected to terminal T1.

If first gate electrodes G1a and G1b are used connected to each other, branch source electrode Sa is not used.

Fig. 5 is an electric circuit diagram showing a semiconductor device according to a third embodiment of the present invention. A DC bias circuit, used to determine the point of operation of the FET, is externally mounted, and bias resistance film 22 serves mainly as a negative-feedback resistance for obtaining stable operating characteristics. Dual-gate MES FETs with first gate electrodes having three different gate widths can be alternatively selected as required by means of an external switching circuit.

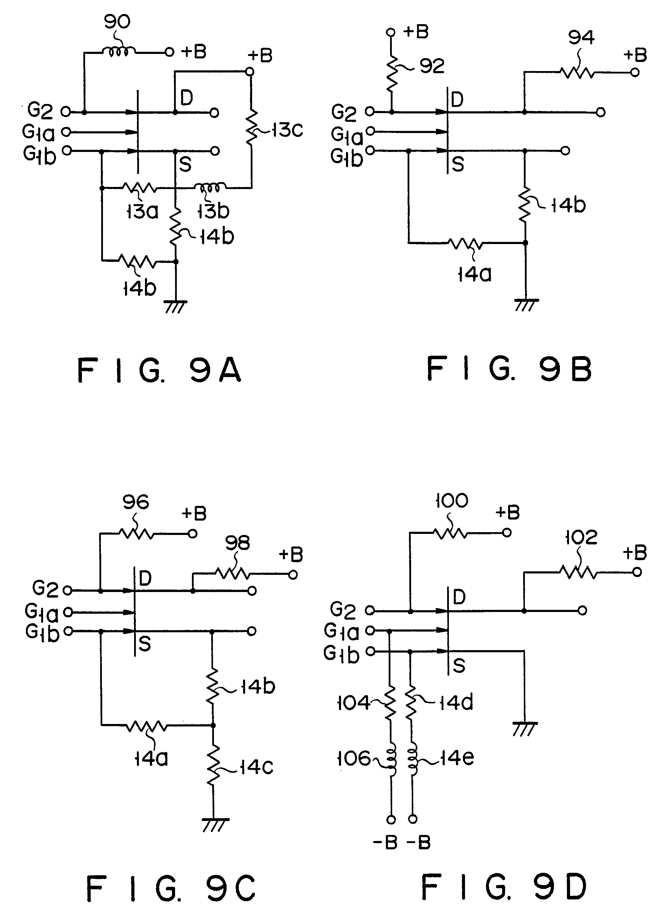

Figs. 9A to 9D show examples of bias circuits used as the gate electrodes (G1a, G1b, G2) of the semiconductor devices of the aforementioned embodiments. These FETs each include divided first gate electrodes G1a and G1b and second gate electrode G2. In Fig. 9A, first gate electrode G1a is open, and electrode G1b is connected to bias voltage +B through resistance elements 13a and 13c and coil element 13b. Second gate electrode G2 is connected to voltage +B through coil element 90. Drain electrode D is connected directly to voltage +B, and source electrode S is grounded through resistance element 14b.

In the FET of Fig. 9B, first gate electrode G1a is open, and electrode G1b is grounded through resistance element 14a. Second gate electrode G2 and drain electrode D are connected to bias voltage +B through resistance elements 92 and 94, respectively. Source electrode S is grounded through resistance element 14b.

In the FET of Fig. 9C, first gate electrode G1a is open, and electrode G1b is grounded through resistance element 14a. Second gate electrode G2 and drain electrode D are connected to bias voltage +B through resistance elements 96 and 98, respectively. Source electrode S is grounded through resistance elements 14b and 14c.

In Fig. 9D, first gate electrode G1a is connected to negative bias voltage -B through resistance element 104 and coil element 106, while first gate electrode G1b is connected to voltage -B through resistance element 14d and coil element 14e. Second gate electrode G2 and drain electrode D are connected to bias voltage +B through resistance elements 100 and 102, respectively. Source electrode S is grounded directly.

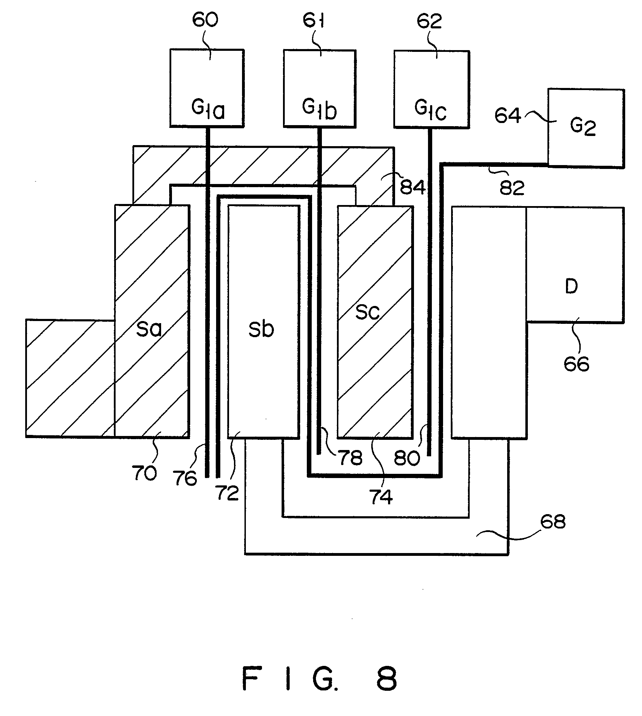

Fig. 8 shows an example of a circuit which includes three divided gate terminals. A finer gate width and wider ranges of electrical characteristics of the FET can be set in this circuit. Naturally, moreover, the gate may be divided into four or more, and the electrical characteristics can be set more minutely.

Although the GaAs dual-gate MES FETs have been described in connection with the illustrative embodiments herein, similar functions and effects can be obtained with use of silicon dual-gate MOS FETs of substantially the same construction. Fig. 1A is a plan view showing a semiconductor device according to an alternative embodiment of the present invention, Fig. 1B is a partial enlarged view of the device of Fig. 1A, and Fig. 1C is a plan view showing a modification of this embodiment. In this arrangement, use of wiring material 30 allows actual gate electrodes to have a capacity equal to the combined capacity of G1a and G1b.

The FET shown in these drawings has the same construction and produces the same effects as the dual FET shown in Fig. 2A, except that it is not provided with the second gate electrode.

According to the present invention, as described above, two MES or MOS FETs, having their respective divided gate electrodes and other electrodes in common, and a bias resistance film are integrated on one substrate, so that the FETs with different gate widths can be selected by means of an external switching circuit. Thus, the semiconductor device of the present invention and its operating method can be applied to a plurality of frequency bands, permitting a high degree of freedom of circuit design and designing of a multi-channel, multi-function version of a high-frequency circuit. Conventionally, different semiconductor devices are used individually in the UHF and VHF bands, for example. According to the invention, however, a single semiconductor device can be applied to both bands by the additional use of a simple external switching circuit. Also, the attachment of only one DC bias circuit is enough, so that the high-frequency circuit can be reduced in size.

## Claims

1. A field-effect transistor structure comprising:
a semiconductor substrate (1);
a drain region (3) and a source region (4) formed on the semiconductor substrate so as to be adjacent to each other;
a drain electrode (5) connected to the drain region;
a source electrode (6) connected to the source region; and
two or more divided gate electrodes (18, 19) disposed between the drain region (3) and the source region (4).

2. The field-effect transistor structure according to claim 1, characterized in that said gate electrodes (18, 19) are situated closer to the source electrode (6) than to the drain electrode (5).

3. The field-effect transistor structure according to claim 1, characterized by further comprising an external switching circuit (SW1, SW2) connected to said gate electrode (18).

4. The field-effect transistor structure according to claim 1, characterized in that an operating layer (2) is formed over the semiconductor substrate (1), with an insulating film interposed therebetween.

5. The field-effect transistor structure according to claim 1, characterized by further comprising a branch source electrode (20) connected to said source electrode (6).

6. The field-effect transistor structure according to claim 1, characterized by further comprising biasing means (14, 15) connected to said source electrode (6).

7. The field-effect transistor structure according to claim 1, characterized in that said gate electrodes (60, 61, 62) are divided in three.

8. The field-effect transistor structure according to claim 1, characterized by further comprising a second gate electrode (7) provided between said drain electrode (5) and said source electrode (6), to constitute a dual gate FET.

F I G. 1A

F I G. 1B

F I G. 1 C

F I G. 2 C

F I G. 2A

F I G. 2B

F I G. 3

F I G. 4

F I G. 5

F I G. 6

6    8    7    2    5

4    N⁺    N    N⁺    3

SEMI - INSULATIVE
GaAs SUBSTRATE    1

F I G. 7

F I G. 8

F I G. 9A

F I G. 9B

F I G. 9C

F I G. 9D